(19) Europäisches Patentamt
European Patent Office
Office européen des brevets

(11) Veröffentlichungsnummer: **0 055 363**
**B1**

# (12) EUROPÄISCHE PATENTSCHRIFT

(45) Veröffentlichungstag der Patentschrift: **14.12.83**

(51) Int. Cl.³: **C 09 B 5/62,** C 08 K 5/00, G 03 G 5/06, H 01 L 31/02

(21) Anmeldenummer: **81108949.9**

(22) Anmeldetag: **27.10.81**

## (54) Perylentetracarbonsäurediimide und deren Verwendung.

(30) Priorität: **27.12.80 DE 3049215**
**20.03.81 DE 3110959**
**17.09.81 DE 3136894**

(43) Veröffentlichungstag der Anmeldung: **07.07.82 Patentblatt 82/27**

(45) Bekanntmachung des Hinweises auf die Patenterteilung: **14.12.83 Patentblatt 83/50**

(84) Benannte Vertragsstaaten: **CH DE FR GB IT LI**

(56) Entgegenhaltungen:
**EP - A - 0 033 079**
**DE - A - 1 807 729**
**DE - A - 2 237 539**
**FR - A - 2 148 510**

(73) Patentinhaber: **BASF Aktiengesellschaft, Carl-Bosch-Strasse 38, D-6700 Ludwigshafen (DE)**

(72) Erfinder: **Graser, Fritz, Dr., Blieskasteler Strasse 17, D-6700 Ludwigshafen (DE)**
Erfinder: **Feichtmayr, Franz, Dr., Mundenheimer Strasse 158, D-6700 Ludwigshafen (DE)**

**EP 0 055 363 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Perylentetracarbonsäurediimide und deren Verwendung

Die Erfindung betrifft neue Perylen-3,4,9,10-tetracarbonsäurediimide und deren Verwendung.

Die neuen Farbstofe, die sich durch sehr gute Echtheitseigenschaften auszeichnen, habe die Formel

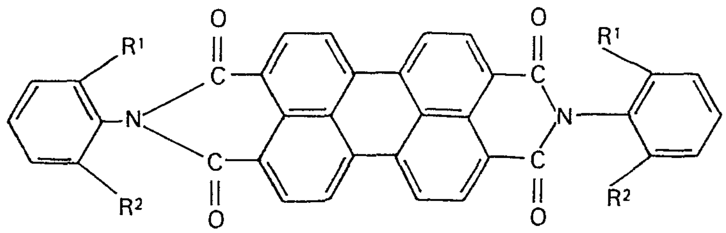

(I),

in der $R^1$ und $R^2$ je Isopropyl oder Chlor oder $R^1$ Methyl oder Ethyl und $R^2$ $C_3$- oder $C_4$-Alkyl bedeuten.

Die Farbstoffe können in an sich bekannter Weise durch Kondensation von Perylen-3,4,9,10-tetracarbonsäure oder deren Anhydrid mit dem entsprechenden 2,6-disubstituierten Anilinen in Lösungs- oder Verdünnungsmitteln, wie Chinolin, Naphthalin oder Trichlorbenzol oder in einem grossen Überschuss der Anilinverbindung bei Temperaturen zwischen 180 und 230°C hergestellt werden. Die Umsetzung führt man zweckmässigerweise in Gegenwart von Mitteln durch, welche die Kondensation beschleunigen, z.B. von Zinkchlorid, Zinkacetat, Zinkpropionat oder Salzsäure.

Aus dem Reaktionsgemisch isoliert man den Farbstoff in üblicher Weise, beispielsweise durch Filtrieren oder Zentrifugieren des 20 bis 80°C warmen Reaktionsgemisches, gegebenenfalls nach dem Verdünnen mit inerten, das Diimid nichtlösenden organischen Flüssigkeiten, vorzugsweise niederen Alkoholen, wie Methanol, Äthanol, Isopropanol oder Isobutanol.

Man kann den Farbstoff auch so isolieren, dass man das gesamte Reaktionsgemisch durch Zugabe einer organischen Flüssigkeit, welche für den Farbstoff ein gutes Lösungsvermögen besitzt, z.B. N-Methylpyrrolidon oder niedere Carbonsäureamide wie Dimethylacetamid oder vorzugsweise Dimethylformamid bei Temperaturen zwischen 50 und 150°C, vorzugsweise zwischen 70 und 120°C in Lösung bringt, die Lösung filtriert und im Filtrat das Diimid mit einer den Farbstoff nicht oder nur wenig lösenden organischen Flüssigkeit z.B. niedere Alkohole, vorzugsweise Methanol gegebenenfalls im Gemisch mit Wasser ausfällt. Der Farbstoff fällt dabei meistens in einer ausreichend reinen Form an.

Zur Entfernung noch vorhandener Spuren an Perylen-3,4,9,10-tetracarbonsäure kann der Farbstoff mit verdünnter Natronlauge oder Sodalösung ausgekocht werden. Falls erforderlich, kann das isolierte Gut zur Entfernung evtl. vorhandener Schwermetallionen mit Komplexbildnern, z.B. Äthylendiamintetraessigsäure/Tetranatriumsalz behandelt werden. Man kann aber auch beide Nachbehandlungen kombinieren. Der Farbstoff kann gegebenenfalls durch Umfällen aus Schwefelsäure oder durch Umkristallisieren noch weiter gereinigt werden.

Die neuen Farbstoffe eignen sich ausgezeichnet zum Einfärben von Kunststoffen, insbesondere von Polystyrol und Hart-PVC in der Masse. Sie liefern sehr klare, leuchtende, fluoreszierende orange Färbungen, die eine sehr gute Lichtechtheit aufweisen. Die Farbstoffe lassen sich auch im Gemisch mit anderen Farbstoffen zum Einfärben von Kunststoffen verwenden, wobei sehr klare, brillante Orange-Färbungen erhalten werden. Die neuen Farbstoffe sind ausserdem hervorragend zur Herstellung von in der DE-A 26 20 115 beschriebenen Kunststoffplatten zur Konzentrierung von Licht geeignet, wobei die neuen Farbstoffe als Fluoreszenzzentren dienen.

Für diesen Zweck sind Farbstoffe I bevorzugt, bei denen $R^1 = R^2$ für Chlor oder $-CH(CH_3)_2$ oder $R^1$ für Methyl oder Ethyl und $R^2$ für $-CH(CH_3)_2$, $-C(CH_3)_3$ oder insbesondere für

$-\underset{\underset{CH_3}{|}}{CH}-C_2H_5$ stehen.

Ganz besonders sind Diimide I hervorzuheben, in denen $R^1 = R^2 =$ Chlor; $R^1 = R^2 =$ Isopropyl oder

$R^1 = -C_2H_5$ und $R^2 = -\underset{\underset{CH_3}{|}}{CH}-C_2H_5$ sind.

Für den letztgenannten Verwendungszweck müssen die Farbstoffe sehr rein sein. Die Syntheseprodukte werden daher Reinigungsoperationen, z.B. fraktioniertes Fällen aus Schwefelsäure, Umkristallisieren usw. oder Kombinationen von Reinigungsoperationen unterzogen.

Für die Verwendung zum Färben von Kunststoffen können in der Regel die Diimide so verwendet werden, wie sie bei der Synthese anfallen.

Der Farbstoff I mit $R^1 = R^2 =$ Chlor ist ausserdem zur Herstellung von elektrophotographischem Aufzeichnungsmaterial sehr gut geeignet. Ein für diese Anwendung besonders geeignetes Diimid (I) wird auf folgendem Wege erhalten: Die Kondensation zu (I) erfolgt in einem grossen Überschuss an 2,6-Dichloranilin, das gleichzeitig als Reaktionsmedium dient. Das Reaktionsgemisch wird in einer das Diimid (I) gut lösenden organischen Flüssigkeit gelöst, warm filtriert und im Filtrat das Diimid gefällt. Eine alkalische Nachbehandlung ist in diesem Fall nicht erforderlich. Perylentetracarbonsäure-bis-arylimide, z.B. die technisch interessanten Arylimide aus p-Aminoazobenzol, p-Phenetidin, p-Anisidin, 3,5-Dimethylanilin oder p-Chloranilin, ergeben bei normalen Verarbeitungstemperaturen Rotfärbungen, die keine Fluoreszenz aufweisen. Mit den neuen Farbstoffen werden dagegen leuchtende Orangefärbungen erhalten, die in transparenter Einfärbung im Tageslicht fluoreszieren. Die neuen Farbstoffe sind in organischen Lösungsmitteln und in Kunststoffen auch wesentlich besser löslich als z.B. die vorstehend genannten Bisarylimide. Als Folge der besseren Löslichkeit wird eine viel bessere Verteilung des neuen Farbstoffs in den Kunststoffen erreicht, so dass vor der Anwendung besondere Feinverteilungs- und Finishmassnahmen nicht zwingend erforderlich sind.

Die im folgenden genannten Teile beziehen sich auf das Gewicht.

Beispiel 1

In 750 Teilen Chinolin werden 98,8 Teile Perylen-3,4,9,10-tetracarbonsäuredianhydrid, 355 Teile 2-(2′-Butyl)-6-ethylanilin, 13,6 Teile Zinkoxid und 40 Teile Eisessig eingetragen. Unter Überleiten eines schwachen Stickstoffstromes erhitzt man auf 225 bis 235°C und hält bei dieser Temperatur, bis eine aufgearbeitete Probe, in verdünnter Kaliumkarbonatlösung aufgekocht, keine Perylentetracarbonsäure mehr anzeigt. Dies ist nach etwa 16 Stunden der Fall. Nach dem Abkühlen auf etwa 80°C wird mit 1000 Teilen Methanol verdünnt, die Suspension auf 4000 Teile Methanol von Raumtemperatur ausgetragen und nach dem Rühren über Nacht filtriert. Das Filtergut wird mit Methanol und anschliessend mit Wasser gewaschen. Das Filtergut rührt man mit 3500 Teilen 2%iger wässriger Kaliumkarbonatlösung an, erhitzt auf etwa 95°C, filtriert, wäscht neutral und trocknet. Spuren möglicherweise noch vorhandener Perylentetracarbonsäure werden dabei entfernt. Man erhält den Farbstoff in sehr guter Ausbeute.

Verwendet man anstelle von Zinkoxid und Eisessig 49 Teile Zinkpropionat, dann erhält man unter sonst gleichen Bedingungen den gleichen Farbstoff ebenfalls in sehr guter Qualität und sehr guter Ausbeute.

Verwendet man anstelle von 2-(2-Butyl)-6-ethylanilin das entsprechende 2-(2-Butyl)-6-methylanilin oder 2-tert.-Butyl-6-ethylanilin dann erhält man die entsprechenden Perylentetracarbonsäurediimide in guter Ausbeute und guter Qualität.

Beispiel 2

In 750 Teilen Chinolin werden 54,9 Teile Perylen-3,4,9,10-tetracarbonsäuredianhydrid, 84 Teile 2-Methyl-6-isopropylanilin, 27,3 Teile Zinkpropionat (wasserfrei) eingetragen. Unter Überleiten eines schwachen Stickstoffstromes erhitzt man auf 225 bis 235°C und hält bei dieser Temperatur, bis eine aufgearbeitete Probe, in verdünnter Kalicarbonatlösung aufgekocht, keine Perylentetracarbonsäure mehr anzeigt. Dies ist nach etwa 14 Stunden der Fall. Nach dem Abkühlen auf etwa 80°C wird mit 5000 Teilen Methanol verdünnt und nach dem Rühren über Nacht filtriert. Das Filtergut wird mit Methanol und anschliessend mit Wasser gewaschen. Das Filtergut rührt man mit 1500 Teilen 2%iger wässriger Kaliumkarbonatlösung an, erhitzt auf etwa 95°C, filtriert, wäscht neutral und trocknet. Spuren möglicherweise noch vorhandener Perylentetracarbonsäure werden dabei entfernt. Man erhält den Farbstoff in sehr guter Ausbeute.

Beispiel 3

Verfährt man wie im Beispiel 2 beschrieben, verwendet aber anstelle von 2-Methyl-6-isopropylanilin 92 Teile 2-Ethyl-6-isopropylanilin, so erhält man das Perylen-3,4,9,10-tetracarbonsäure-bis-(2′-ethyl-6-isopropylanilid) in sehr guter Ausbeute.

Beispiel 4

In 750 Teilen Chinolin werden bei 100°C 29,4 Teile wasserfreies Zinkpropionat, 59 Teile Perylen-3,4,9,10-tetracarbonsäuredianhydrid und 194 Teile 2,6-Dichloranilin eingetragen. Unter Überleiten eines schwachen Stickstoffstromes erhitzt man auf 225 bis 230°C und hält bei dieser Temperatur, bis eine aufgearbeitete Probe, in verdünnter Sodalösung aufgekocht, keine Perylentetracarbonsäure mehr anzeigt. Dies ist nach etwa 7 Stunden der Fall. Nach dem Abkühlen auf etwa 80°C wird mit 800 Teilen Methanol verdünnt und die Suspension bei 40°C filtriert. Das Filtergut wird mit Methanol und anschliessend mit Wasser gewaschen. Das Filtergut rührt man mit etwa 1200 Teilen 2%iger wässriger Sodalösung an, erhitzt auf etwa 95°C, filtriert, wäscht neutral und trocknet. Spuren möglicherweise noch vorhandener Perylentetracarbonsäure werden dabei entfernt. Man erhält den Farbstoff in sehr guter Ausbeute.

An Stelle von 29,4 Teilen wasserfreies Zinkpropionat können mit gleichem Ergebnis auch 8,1 Teile Zinkoxid und 24 Teile Essigsäure als die Kondensation beschleunigendes Mittel verwendet werden.

Beispiel 5

In 500 Teile 2,6-Dichloranilin werden bei 50 bis 60°C 6,8 Teile Zinkoxid, 20,4 Teile Essigsäure und 50 Teile Perylentetracarbonsäuredianhydrid eingetragen. Unter Überleiten eines schwachen Stickstoffstromes erhitzt man auf 220 bis 225°C und hält 18 Stunden bei dieser Temperatur. Nach dem Abkühlen auf 70°C giesst man das Reaktionsgemisch unter Rühren in 2500 Teile Dimethylformamid, erwärmt auf 95 bis 100°C und rührt etwa 15 Minuten bei dieser Temperatur nach. Man filtriert von unlöslichen Anteilen ab und wäscht den Filterrückstand mit etwa 250 Teilen warmem Dimethylformamid aus. Aus dem Filtrat kristallisiert beim Erkalten ein Teil des Farbstoffs

aus. Durch Zugabe von 3500 Teilen Methanol wird weiterer Farbstoff ausgefällt. Man filtriert den Farbstoff ab, wäscht zuerst mit Methanol und dann mit heissem Wasser aus und trocknet.

Man erhält das Perylen-3,4,9,10-tetracarbonsäure-bis-(2′,6′-dichloranilid) praktisch frei von Perylentetracarbonsäure in Form eines Pulvers, das sich sehr gut zur Herstellung von elektrophotographischem Aufzeichnungsmaterial eignet.

Beispiel 6

In 750 Teilen Chinolin werden 98,4 Teile Perylen-3,4,9,10-tetracarbonsäuredianhydrid, 354 Teile 2,6-Diisopropylanilin, 13,6 Teile Zinkoxid und 40 Teile Eisessig eingetragen. Unter Überleiten eines schwachen Stickstoffstromes erhitzt man auf 225 bis 235°C und hält bei dieser Temperatur, bis eine aufgearbeitete Probe, in verdünnter Sodalösung aufgekocht, keine Perylentetracarbonsäure mehr anzeigt. Dies ist nach etwa 10 Stunden der Fall. Nach dem Abkühlen auf etwa 80°C wird mit 1000 Teilen Methanol verdünnt, die Suspension auf 8000 Teile Methanol von Raumtemperatur ausgetragen und nach dem Rühren über Nacht filtriert. Das Filtergut wird mit Methanol und anschliessend mit Wasser gewaschen. Das Filtergut rührt man mit 3500 Teilen 2%iger wässriger Sodalösung an, erhitzt auf etwa 95°C, filtriert, wäscht neutral und trocknet. Spuren möglicherweise noch vorhandener Perylentetracarbonsäure werden dabei entfernt. Man erhält den Farbstoff in sehr guter Ausbeute.

Analyse

$C_{48}$ $H_{42}$ $O_4$ $N_2$ (M.710)

| | | | | |
|---|---|---|---|---|
| ber. | 81,1%C | 6,0%H | 9,0%O | 3,9%N |
| gef. | 79,8 | 5,7 | 9,6 | 4,4 |

Beispiel 7

In 750 Teilen Chinolin werden 98,6 Teile Perylen-3,4,9,10-tetracarbonsäuredianhydrid, 356 Teile 2,6-Diisopropylanilin und 49 Teile Zinkpropionat (wasserfrei) eingetragen. Unter Überleiten eines schwachen Stickstoffstromes erhitzt man auf 225 bis 235°C und hält bei dieser Temperatur, bis eine aufgearbeitete Probe, in verdünnter Kaliumcarbonatlösung aufgekocht, keine Perylentetracarbonsäure mehr anzeigt. Dies ist nach etwa 10 Stunden der Fall. Nach dem Abkühlen auf etwa 80°C wird mit 1000 Teilen Methanol verdünnt, die Suspension auf 5000 Teile Methanol von Raumtemperatur ausgetragen und nach dem Rühren über Nacht filtriert. Das Filtergut wird mit Methanol und anschliessend mit Wasser gewaschen. Das Filtergut rührt man mit 3500 Teilen 2%iger wässriger Kaliumcarbonatlösung an, erhitzt auf etwa 95°C, filtriert, wäscht neutral und trocknet. Spuren möglicherweise noch vorhandener Perylentetracarbonsäure werden dabei entfernt. Man erhält den Farbstoff in sehr guter Ausbeute.

Anwendungsbeispiel 1

0,05 Teile des nach Beispiel 1 erhaltenen Diimids werden in einem Schnellmischer mit 100 Teilen gemahlenem Polystyrol-Blockpolymerisat trocken gemischt. Das Gemisch wird auf einer Schneckenpresse bei einer Zylindertemperatur von 200 bis 250°C geschmolzen und homogenisiert. Die gefärbte plastische Masse wird durch Heissabschlagen am Düsenkopf oder durch Ausziehen von Fäden unter Kühlung granuliert. Das so erhaltene Granulat wird anschliessend in einer Spritzgussvorrichtung bei 200 bis 250°C zu Formkörpern verspritzt oder auf Pressen zu beliebigen Körpern verpresst. Man erhält leuchtend orangefarbene Spritzlinge oder Presslinge, die fluoreszieren. Die Färbungen weisen sehr gute Lichtechtheit auf.

Anstelle von Polystyrol-Blockpolymerisat kann auch ein Polystyrol-Emulsionspolymerisat, ein Suspensionspolymerisat oder ein Mischpolymerisat von Styrol mit Butadien und Acrylnitril oder Acrylestern verwendet werden.

Entsprechende Färbungen erhält man mit den nach den Beispielen 2 oder 3 erhaltenen Bisimiden.

Anwendungsbeispiel 2

0,05 Teile Perylen-3,4,9,10-tetracarbonsäure-bis(2′,6′-dichloranilid) (hergestellt nach Beispiel 4) werden in einem Schnellmischer mit 100 Teilen gemahlenem Polystyrol-Blockpolymerisat trokken gemischt. Das Gemisch wird auf einer Schneckenpresse bei einer Zylindertemperatur von 200 bis 250°C geschmolzen und homogenisiert. Die gefärbte plastische Masse wird durch Heissabschlagen am Düsenkopf oder durch Ausziehen von Fäden unter Kühlung granuliert. Das so erhaltene Granulat wird anschliessend in einer Spritzgussvorrichtung bei 200 bis 250°C zu Formkörpern verspritzt oder auf Pressen zu beliebigen Körpern verpresst. Man erhält leuchtend orangefarbene Spritzlinge oder Presslinge, die fluoreszieren und in der Durchsicht blaustichig rot aussehen. Die Färbungen weisen sehr gute Lichtechtheit auf.

Anstelle von Polystyrol-Blockpolymerisat kann auch ein Polystyrol-Emulsionspolymerisat, ein Suspensionspolymerisat oder ein Mischpolymerisat von Styrol mit Butadien und Acrylnitril oder Acrylestern verwendet werden.

Anwendungsbeispiel 3

0,05 Teile Perylen-3,4,9,10-tetracarbonsäure-bis(2′,6′-diisopropylanilid) (erhalten nach Beispiel 6) werden in einem Schnellmischer mit 100 Teilen gemahlenem Polystyrol-Blockpolymerisat trocken gemischt. Das Gemisch wird auf einer Schneckenpresse bei einer Zylindertemperatur von 200 bis 250°C geschmolzen und homogenisiert. Die gefärbte plastische Masse wird durch Heissabschlagen am Düsenkopf oder durch Ausziehen von Fäden unter Kühlung granuliert. Das so erhaltene Granulat wird anschliessend in einer Spritzgussvorrichtung bei 200 bis 250°C zu Formkörpern verspritzt oder auf Pressen zu beliebigen Körpern verpresst. Man erhält leuchtend orangefarbene Spritzlinge oder Presslinge, die fluoreszieren. Die Färbungen weisen sehr gute Lichtechtheit auf.

Anstelle von Polystyrol-Blockpolymerisat kann auch ein Polystyrol-Emulsionspolymerisat, ein Suspensionspolymerisat oder ein Mischpolymerisat von Styrol mit Butadien und Acrylnitril oder Acrylestern verwendet werden.

**Patentansprüche**

1. Perylen-3,4,9,10-tetracarbonsäurediimide der Formel

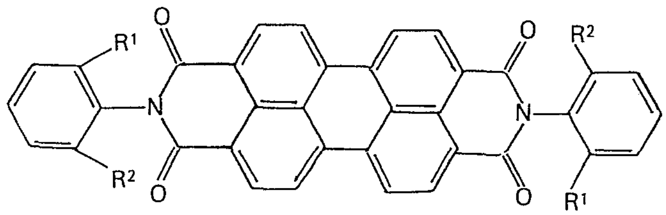

in der
$R^1$ und $R^2$ je Isopropyl oder Chlor oder
$R^1$ Methyl oder Ethyl und
$R^2$ $C_3$- oder $C_4$-Alkyl bedeuten.

2. Perylentetracarbonsäurediimid gemäss Anspruch 1, dadurch gekennzeichnet, dass $R^1$ und $R^2$ für Chlor stehen.

3. Perylentetracarbonsäurediimid gemäss Anspruch 1, dadurch gekennzeichnet, dass $R^1$ und $R^2$ für Isopropyl stehen.

4. Perylentetracarbonsäurediimid gemäss Anspruch 1, dadurch gekennzeichnet, dass $R^1$ für Methyl oder Ethyl und $R^2$ für 2-Propyl, 2-Butyl oder tert.-Butyl stehen.

5. Perylentetracarbonsäurediimid gemäss Anspruch 4, dadurch gekennzeichnet, dass $R^2$ für 2-Butyl steht.

6. Perylentetracarbonsäurediimid gemäss Anspruch 1, dadurch gekennzeichnet, dass $R^1$ für Ethyl und $R^2$ für 2-Butyl stehen.

7. Verwendung von Perylentetracarbonsäurediimid gemäss den Ansprüchen 1 bis 6 zum Färben von Kunststoffen in der Masse.

8. Verwendung von Perylentetracarbonsäurediimid gemäss den Ansprüchen 1 bis 6 zur Konzentrierung von Licht.

**Claims**

1. A perylene-3,4,9,10-tetracarboxylic acid diimide of the formula

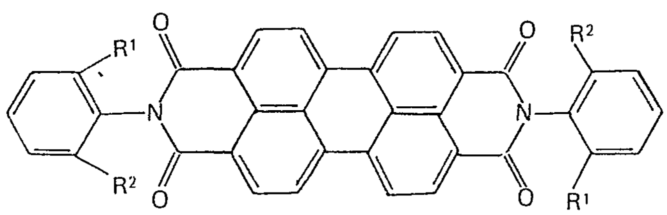

where $R^1$ and $R^2$ are each isopropyl or chlorine or $R^1$ is methyl or ethyl and $R^2$ is $C_3$- or $C_4$-alkyl.

2. A perylenetetracarboxylic acid diimide as claimed in claim 1, wherein $R^1$ and $R^2$ are each chlorine.

3. A perylenetetracarboxylic acid diimide as claimed in claim 1, wherein $R^1$ and $R^2$ are each isopropyl.

4. A perylenetetracarboxylic acid diimide as claimed in claim 1, wherein $R^1$ is methyl or ethyl and $R^2$ is prop-2-yl, but-2-yl or tert.-butyl.

5. A perylenetetracarboxylic acid diimide as claimed in claim 4, wherein $R^2$ is but-2-yl.

6. A perylenetetracarboxylic acid diimide as claimed in claim 1, wherein $R^1$ is ethyl and $R^2$ is butyl-2-yl.

7. The use of a perylenetetracarboxylic acid diimide as claimed in claims 1 to 6 for mass-colouring plastics materials.

8. The use of a perylenetetracarboxylic acid diimide as claimed in claims 1 to 6 for concentrating light.

**Revendications**

1. Diimides d'acide pérylène-3,4,9,10-tétracarboxylique de formule

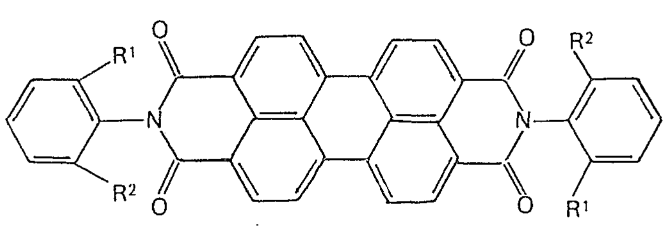

dans laquelle

$R^1$ et $R^2$ représentent chacun un isopropyle ou un chlore ou
$R^1$ représente un méthyle ou un éthyle et
$R^2$ représente un alcoyle en $C_3$ ou $C_4$.

2. Diimide d'acide pérylène-tétracarboxylique selon la revendication 1, caractérisé en ce que $R^1$ et $R^2$ sont mis chacun pour un chlore.

3. Diimide d'acide pérylène-tétracarboxylique selon la revendication 1, caractérisé en ce que $R^1$ et $R^2$ sont mis chacun pour un isopropyle.

4. Diimide d'acide pérylène-tétracarboxylique selon la revendication 1, caractérisé en ce que $R^1$ est mis pour un méthyle ou un éthyle et $R^2$ pour un 2-propyle, un 2-butyle ou un tertiobutyle.

5. Diimide d'acide pérylène-tétracarboxylique selon la revendication 4, caractérisé en ce que $R^2$ est mis pour un 2-butyle.

6. Diimide d'acide pérylène-tétracarboxylique selon la revendication 1, caractérisé en ce que $R^1$ est mis pour un éthyle et $R^2$ pour un 2-butyle.

7. Utilisation d'un diimide d'acide pérylène-tétracarboxylique selon l'une quelconque des revendications 1 à 6 pour la coloration de matières synthétiques dans la masse.

8. Utilisation d'un diimide d'acide pérylène-tétracarboxylique selon l'une quelconque des revendications 1 à 6 pour la concentration de lumière.